# EUROPEAN PATENT APPLICATION

(11) **EP 4 332 277 A1**
(43) Date of publication of application: **06.03.2024**
(21) Application number: 22192691.8
(22) Date of filing: 29.08.2022
(51) Int. Cl.: C25D 17/06, C23G 3/02, H01L 21/687, B08B 3/04, B05C 5/00

(54) **APPARATUS AND METHOD FOR NON-IMMERSIVE WET-CHEMICAL TREATMENT OF A PLANAR SUBSTRATE AND DEVICE FOR HOLDING THE SUBSTRATE**

(71) Applicant: Atotech Deutschland GmbH & Co. KG, 10553 Berlin (DE)
(72) Inventor: Schirmer, Christian, 10553 Berlin (DE); Schafsteller, Britta, 10553 Berlin (DE); Weinhold, Ray, 10553 Berlin (DE); Kiehl, Markus, 10553 Berlin (DE); Jang, Don, 10553 Berlin (DE); Lorenz, Olaf, 10553 Berlin (DE); Gaul, Florian, 10553 Berlin (DE)

(57) **Abstract**

A device for holding a planar substrate (1) in an apparatus for non-immersive wet-chemical treatment of the substrate (1) comprises a support structure (34). The support structure (34) comprises at least one part (36a,b) for engaging a support such as to suspend the support structure (34) in the apparatus. The device comprises at least one clamping device, supported by the support structure (34), for holding the substrate (1) in a plane; and at least a first upper flow guidance part (37), arranged on one side of the plane and having an inward-facing surface (44) facing inwards and an outward-facing surface facing outwards with respect to the plane. The outward-facing surface comprises an upper outward-facing surface section (46), wettable by a stream of liquid directed onto the upper outward-facing surface section (46), and a lower outward-facing surface section (47), extending from a transition between at least a central part of the upper outward-facing surface section (46) and the lower outward-facing surface section (47) to a lower edge (49). A strip (45) of the inward-facing surface extends longitudinally along the lower edge (49) and transversely up to the lower edge (49). At least a central longitudinal section of the strip (45) is movable into engagement with a major surface of the substrate (1) over an entire length of that section.

## Description

### Technical Field

The invention relates to a device for holding a planar substrate in an apparatus for non-immersive wet-chemical treatment of the substrate, the device comprising:
a support structure,
wherein the support structure comprises at least one part for engaging a support such as to suspend the support structure in the apparatus;
at least one clamping device, supported by the support structure, for holding the substrate in a plane; and
at least a first upper flow guidance part, arranged on one side of the plane and having an inward-facing surface facing inwards and an outward-facing surface facing outwards with respect to the plane,
wherein the outward-facing surface comprises:
   an upper outward-facing surface section wettable by a stream of liquid directed onto the upper outward-facing surface section, and
   a lower outward-facing surface section, extending from a transition between at least a central part of the upper outward-facing surface section and the lower outward-facing surface section to a lower edge, and
   wherein a strip of the inward-facing surface extends longitudinally along the lower edge and transversely up to the lower edge.

The invention also relates to an apparatus for non-immersive wet-chemical treatment of a planar substrate, comprising at least one such device.

The invention also relates to a method of non-immersive wet-chemical treatment of a planar substrate.

### Background Art

US 10,513,779 B2 discloses a surface treating system. A substrate is pinched and held at an upper end by clips of a hanger. In one embodiment, pipes as treatment solution releasing sections are provided on both sides of the substrate held by the hanger. Each pipe has holes so that a treatment solution can be discharged obliquely upward. The discharged treatment solution flows down the surfaces of the substrate and reaches the bottom, and is circulated and discharged from the pipes again by a pump. In an alternative embodiment, the treatment solution is discharged obliquely downward from slopes. The treatment solution pumped up by the pump is stored in reservoirs. When the liquid level gets higher than the edges of the slopes, the treatment solution overflows onto the slopes. The treatment solution having overflowed onto the slopes contacts treatment solution receiving members of the hanger and flows down onto the substrate. The treatment solution receiving members extend across the entire width of the hanger and are provided across the tips of clips. Each treatment solution receiving member has a flat plate forming a proximal portion thereof and, in one embodiment, a projected section raised in a semi-circular shape to form a distal portion thereof. Gripping projections for pinching and grasping the substrate are provided along an inner lower end of each projected section. Adhesion prevention projections are provided to prevent the substrate from bending at portions without the gripping projections. It is preferred that the treatment solution flow from the treatment solution receiving members onto the substrate at an angle close to a right angle to the surfaces. Alternatively, the flat plates may be formed thick (preferably 20 mm to 40 mm) with a rounded outer edge (preferably R = 10 mm or greater).

A problem of the known device is that the liquid flowing onto the substrate is apt to form eddies there, which impacts on the uniformity of surface treatment at this location.

### Summary of Invention

It is an object of the invention to provide a device, apparatus and method of the types mentioned above in the opening paragraphs that allow for relatively uniform surface treatment up to at least close to an upper edge of an exposed region of the major surface of the substrate.

The object is achieved according to a first aspect by the device according to the invention, which is characterised in that at least a central longitudinal section of the strip is movable into engagement with a major surface of the substrate over an entire length of that section.

The device is suitable for holding a planar substrate in an apparatus for non-immersive wet-chemical treatment during the treatment. In this type of treatment, the substrate is not immersed in a bath of processing liquid, but held in the apparatus and wetted by means of liquid directed onto, in this case, the upper flow guidance part. From there, the liquid flows downwards onto an exposed region of a major surface of the substrate to effect the treatment. The liquid then drops onto the bottom of a basin or tank comprised in the apparatus.

The planar substrate may be flexible, such that the substrate is only planar when held by the clamping devices.

The device comprises a support structure comprising at least one part for engaging a support such as to suspend the support structure in the apparatus. Thus, the configuration and orientation of the at least one part for engaging the support determine which way up the device is oriented, in use, and thus which outward-facing surface section is the upper outward-facing surface section and which the lower outward-facing surface section. Similarly, the position, orientation and configuration of the at least one clamping devices determine the location and orientation of the plane, which can thus be determined even in the absence of a substrate.

The device comprises at least a first upper flow guidance part, arranged on one side of the plane and having an inward-facing surface facing inwards and an outward-facing surface facing outwards with respect to the plane. That is to say that the first upper flow guidance part does not cross the plane, but has an inward-facing surface facing in the direction of the plane and an outward-facing surface that does not face in the direction of the plane, not even obliquely. In this context, the direction in which the inward-facing surface faces has at least a component perpendicular to the plane. The outward-facing surface faces in a direction having no such component. In principle, the outward-facing surface may comprise a section facing in a direction exactly parallel to the plane, however.

The inward-facing surface and the outward-facing surface need not be entirely flat. The outward-facing surface is generally unobstructed and wettable by a stream of liquid directed onto the upper outward-facing surface section. A lower outward-facing surface section is contiguous with the upper outward-facing surface section, or at least a central section thereof, and extends to a lower edge of the outward-facing surface section. This will also be a lower edge of the first upper flow guidance part. The lower edge may be a straight edge or curve. Embodiments with a straight edge are relatively easy to implement. It is possible to define a strip of the inward-facing surface of which, in use, at least a central section (seen in longitudinal direction along the length of the edge) is movable into engagement with a major surface of any planar substrate located in the plane defined by the at least one clamping devices. Thus, there is no gap between the lower edge and the major surface. Engagement between at least the central section of the strip and the major surface of the substrate will be essentially uninterrupted over the length of that central section. Any liquid flowing down over the upper and lower outward-facing surface sections will encounter a smooth transition to the exposed region of the major surface of the planar substrate onto and over which the flow continues as an equalised film flow, in use. There are relatively few, or no, eddies, ensuring uniform treatment of the exposed region of the major surface of the substrate up to or close up to the line of contact with the lower edge.

A central longitudinal section of the strip is a section in the middle, seen looking onto the outward-facing or inward-facing surface. Where the lower edge is rounded at corners at the longitudinal ends, there may be no engagement with the flat major surface of a planar substrate. In many embodiments, the strip will be movable into engagement with a major surface of a planar substrate over an entire length of the strip.

Depending on whether both major surfaces of the substrate are to be treated there may be a second upper flow guidance part on an opposite side of the plane. Generally, there may be at most one upper flow guidance part for any one of the two sides. The lower edge will in most cases extend over a maximum dimension of an exposed region of the major surface of any substrate held in the plane by the clamping devices. This dimension will in most cases be determined by the support structure, which will normally frame the region of the plane in which a substrate can be held.

The strip of the inward-facing surface need not be flat on a micro-level, in particular if made of a material with a substantially different hardness from that of the substrate surface.

The strip may have an increased surface roughness compared with other parts of the inward-facing surface.

In an embodiment of the device, the at least one clamping devices comprise at least one upper clamping device, and an arm of the upper clamping device is arranged to engage a major surface of the substrate at a level equal to or higher than the strip.

An effect is that the arm does not disturb the flow of liquid from the first upper flow guidance part onto and over the major surface of the substrate.

In an example of this embodiment, the arm of the upper clamping device is arranged to engage the major surface between the plane and the strip.

Thus, clamping engagement is between the upper flow guidance part and the major surface of the substrate. This can be close to the, in use, upper edge of the planar substrate, so that the vast majority of the major surface of the substrate is exposed and treatable.

In an example of any embodiment in which the at least one clamping devices comprise at least one upper clamping device and an arm of the upper clamping device is arranged to engage a major surface of the substrate at a level equal to or higher than the strip, the first upper flow guidance part forms the arm of the upper clamping device.

Thus, separate clamping devices are not required and the device can be relatively compact and have relatively few parts. The other arm of the upper clamping device may be a part comprised in or fixed to the support structure of the device.

An embodiment of the device further comprises a second of the upper flow guidance parts, arranged on an opposite side of the plane to the first upper flow guidance part.

This embodiment is suitable for treating both major surfaces of a planar substrate relatively uniformly. The second upper flow guidance part may comprise the features of any or all of the embodiments of the first upper flow guidance part. In many such cases, the second upper flow guidance part will be at least a mirror image (with respect to the plane) of the first upper flow guidance part, if not identical in shape and dimensions.

In an example of any embodiment of the device in which the device further comprises a second of the upper flow guidance parts, arranged on an opposite side of the plane to the first upper flow guidance part, the first and second upper flow guidance parts are arranged to clamp the planar substrate between them.

There is therefore no need for any further upper clamping devices. This makes the device relatively compact and saves on parts. One or more elastic components may be provided to urge the first and second flow guidance parts, more particularly the strips of the inward-facing surfaces thereof, towards each other. Because at least a central longitudinal section of the strip is movable into engagement with a major surface of the planar substrate over an entire length of that section, there is a relatively long area of contact extending over substantially the width of the substrate. This helps prevent damage to the substrate surface. Furthermore, where the substrate is held under tension, the tension is relatively uniformly distributed over the width of the substrate.

In an embodiment of the device, at least the first of the upper flow guidance parts is pivotably attached to the support structure, with a pivot axis extending parallel to the plane.

It is thus relatively easy to move the strip or central section thereof into engagement with the major surface of the planar substrate, regardless of the exact thickness of the planar substrate. One or more biasing devices may be provided between the support structure and the pivoting upper flow guidance part or parts to bias the strip towards the plane. If the lower edge is straight, the lower edge will be at least approximately parallel to the pivot axis. Pivotable attachment may be through pivots projecting from one of the support structure and the upper flow guidance part, which pivots are inserted through respective apertures in the other of the support structure and the upper flow guidance part.

In an embodiment, at least the first of the upper flow guidance parts is made at least partly of plate-shaped segments defining at least the inward-facing surface and the outward-facing surface.

This makes the upper flow guidance part relatively easy to manufacture by cutting the segments from plate-shaped material and joining these together, e.g. by welding or bonding. Parts of the upper flow guidance part for attaching the upper flow guidance part to the support structure need not be made of plate-shaped segments. At least those parts defining the inward-facing surface and the outward-facing surface will generally be made of one or more plate-shaped segments.

In an embodiment of the device, the outward-facing surface section folds inward towards the plane at a transition from the upper outward-facing surface section to the lower outward-facing surface section.

In particular in combination with the features of the previous embodiment, this embodiment is relatively easy to manufacture. The transition may be along a straight line, e.g. a straight line parallel to the lower edge, for uniform flow across the width of the outward-facing surface (seen looking onto that surface in the direction of the plane). The embodiment allows one or both of the upper and lower outward-facing surface sections to be flat, yet face in a different direction from the other of the upper and lower outward-facing surface sections.

In an embodiment of the device, at least one of the upper outward-facing surface section and the lower outward-facing surface section is flat over at least a majority of a surface area thereof.

This provides for unobstructed flow across the surface section concerned.

In an embodiment, at least the upper outward-facing surface section is bounded laterally by surfaces facing towards each other and extending at an angle, e.g. transversely, to the plane.

The upper outward-facing surface section is the one on which the stream of processing liquid impinges, in use. The surfaces facing towards each other and extending at an angle to the plane bound the upper outward-facing surface section so that liquid cannot flow off the upper outward-facing surface section at the lateral edges thereof, but is forced to flow onto the lower outward-facing surface section.

In an embodiment of the device, the lower edge extends between lateral edges of the lower outward-facing surface section, the lateral edges meeting the lower edge at respective corners of the lower outward-facing surface section.

The lower outward-facing surface section is thus essentially lip-shaped. The lateral edges may abut or be situated closely adjacent to members of the support structure, such that the lower outward-facing surface section extends partly between these members. The lateral edges may be straight over the majority of their extent, as may be the lower edge.

In an example of the embodiment in which the lower edge extends between lateral edges of the lower outward-facing surface section, the lateral edges meeting the lower edge at respective corners of the lower outward-facing surface section, the outward-facing surface further comprises lateral lower outward-facing surface sections, separate from the lower outward-facing surface section and adjoining the upper outward-facing surface section, and the lateral lower outward-facing surface sections and the upper outward-facing surface section extend at an angle smaller than 180° between each other.

Whereas the lower outward-facing surface section slopes inwards in the direction of the plane towards the lower edge, the lateral lower outward-facing surface sections thus slope outwards towards their lower edges. This helps carry processing liquid away from parts of the support structure that frame the substrate laterally, in use. Furthermore, where the surface sections are defined by plate-shaped segments, the lateral lower outward-facing surface sections enhance the rigidity of the upper flow guidance part.

In an embodiment of the device, the at least one clamping devices comprise at least one lower clamping device, arranged to engage the substrate at a lower edge of the substrate.

This allows the device to be used to hold relatively flexible substrates in a well-defined position in the plane. The substrate is unlikely to swing or warp.

An embodiment of the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section.

The lower flow guidance part guides the film flow arriving at the bottom edge of the exposed region of the major surface of the substrate away from the device. This may help shield the support structure and/or lower clamping devices from the processing liquid. If there is only one (first) upper flow guidance part and only one (first) lower flow guidance part, they will be located on the same side of the plane in which the substrate is arranged to be held (relative to a normal to the plane). That is to say that their respective inward-facing surfaces will face in parallel directions towards the plane.

In an example of any embodiment in which the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section, the upper edge extends between lateral edges of the upper outward-facing surface section, the lateral edges meeting the upper edge at respective corners of the upper outward-facing surface section.

This embodiment is easy to manufacture with a straight upper edge and thus straight strip. A continuous line of contact with the flat major surface of the planar substrate can be achieved relatively easily.

In an example of this embodiment, the lateral edges extend from the respective corners to respective second corners of the upper outward-facing surface section, and the upper outward-facing surface section widens at the second corners to increase an extent of the upper outward-facing surface section in a direction parallel to the upper edge.

In this embodiment, the part of the lower flow guidance part that defines the upper outward-facing surface section may be folded in between lateral members of the support structure that frame the region of the plane in which the substrate is arranged to be held.

In an example of any embodiment in which the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section, at least a section of the upper outward-facing surface section is bounded laterally by surfaces facing towards each other and extending at an angle, e.g. transversely, to the plane.

These surfaces facing towards each other and extending at an angle, e.g. transversely, to the plane, guide the liquid flowing from the major surface of the substrate onto the lower flow guidance part downwards without spreading out. As a consequence, the flow across the major surface being treated is also relatively uniform at the bottom edge of an exposed region thereof.

In an example of any embodiment in which the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section, the outward-facing surface of the lower flow guidance part comprises a lower outward-facing surface section adjoining the upper outward-facing surface section, and the upper outward-facing surface section and the lower outward-facing surface section extend at an angle larger than 180° between each other.

The lower outward-facing surface section may be at a relatively small or negligible angle to the vertical in use, whereas the upper outward-facing surface section slopes. The lower outward-facing surface section may shield lower parts of the support structure or clamping devices. In any case, an effect is that the equalised film flow does not become detached at the lower end of the upper outward-facing surface section.

In an example of any embodiment in which the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section, at least the upper outward-facing surface section is flat.

This provides for smooth, uniform, unobstructed flow across the upper outward-facing surface section.

In an example of any embodiment in which the at least one clamping devices comprise at least one lower clamping device, arranged to engage the substrate at a lower edge of the substrate and the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section, an arm of the lower clamping device is arranged to engage a major surface of the substrate at a level equal to or lower than the strip of the first lower flow guidance part.

Thus, the lower clamping device arm does not disrupt the flow across the major surface of the substrate at the lower end of the exposed region of that major surface.

In an example of this embodiment, the arm of the lower clamping device is arranged to engage the major surface between the plane and the strip of the first lower flow guidance part.

Thus, the lower clamping device and the first lower flow guidance part can be provided at the same level or even coincide.

In an example of any embodiment in which the at least one clamping devices comprise at least one lower clamping device, arranged to engage the substrate at a lower edge of the substrate and the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, wherein at least a central longitudinal section of the strip is movable into engagement with a major surface of a substrate over an entire length of that section, and wherein an arm of the lower clamping device is arranged to engage a major surface of the substrate at a level equal to or lower than the strip of the first lower flow guidance part. the first lower flow guidance part forms the arm of the lower clamping device.

Thus, there is no need to provide separate clamping devices. Moreover, the strip can engage the substrate to clamp the substrate. Because at least a central longitudinal section of the strip is movable into engagement with a major surface of a substrate over an entire length of that section, there is a relatively extended contact area between the clamping device and the substrate. Where the substrate is held under tension, this tension is uniformly distributed. In any case, there are no acute stresses on isolated patches of the substrate surface.

In an example of any embodiment in which the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section, the device further comprises a second of the lower flow guidance parts, arranged on an opposite side of the plane to the first lower flow guidance part.

In this embodiment, both major surfaces of the substrate can be treated simultaneously. The second lower flow guidance part may comprise any of the features of any of the embodiments of the first lower flow guidance part. The second lower flow guidance part may be at least the mirror image of the first lower flow guidance part (with respect to the plane), e.g. identical in shape and dimensions.

In an example of any embodiment in which the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, wherein at least a central longitudinal section of the strip is movable into engagement with a major surface of a substrate over an entire length of that section, and wherein the device further comprises a second of the lower flow guidance parts, arranged on an opposite side of the plane to the first lower flow guidance part, the first and second lower flow guidance parts are arranged to clamp the substrate between them.

Thus, separate clamping devices are not required. The device is well-suited for use in holding substrates of different thickness.

In an example of any embodiment in which the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section, at least the first of the lower flow guidance parts is pivotably attached to the support structure with a pivot axis extending parallel to the plane.

This makes it relatively easy to move the strip of the inward-facing surface into engagement with the surface of the substrate. One or more biasing devices may be provided between the support structure and the pivoting lower flow guidance part or parts to bias the strip of the inwards-facing surface towards the plane. If the upper edge is straight, the upper edge will be at least approximately parallel to the pivot axis. Pivotable attachment may be through pivots projecting from one of the support structure and the lower flow guidance part, which pivots are inserted through respective apertures in the other of the support structure and the lower flow guidance part.

In an example of any embodiment in which the device further comprises at least a first lower flow guidance part, arranged on a respective side of the plane and having an inward-facing surface facing inwards and an outward-facing surface facing outwards with respect to the plane, wherein the outward-facing surface comprises at least an upper outward-facing surface section extending to an upper edge of the outward-facing surface and slanting inwards towards the plane in the direction of the upper edge, wherein a strip of the inward-facing surface extends longitudinally along the upper edge and transversely up to the upper edge, and wherein at least a central longitudinal section of the strip is movable into engagement with a major surface of a substrate over an entire length of that section, at least the first of the lower flow guidance parts is comprised of plate-shaped segments defining at least the inward-facing surface and the outward-facing surface.

This makes the lower flow guidance part relatively easy to manufacture by cutting the segments from plate-shaped material and joining these together, e.g. by welding or bonding. Parts of the lower flow guidance part for attaching the lower flow guidance part to the support structure need not be made of plate-shaped segments. At least those parts defining the inward-facing surface and the outward-facing surface will generally be made of one or more plate-shaped segments, however.

According to another aspect, the apparatus for non-immersive wet-chemical treatment of a planar substrate according to the invention comprises at least one device according to the invention, at least one treatment station and at least one support to at least suspend the device in the treatment station, wherein the treatment station includes a system for directing a respective stream of liquid onto the upper outward-facing surface section of a respective one of the at least one upper flow guidance parts.

The device according to the invention may be configured to hold the substrate and to be conveyed through the apparatus by a conveying system, in particular where the apparatus comprises a plurality of treatment stations. Because the stream of liquid is directed onto the upper outward-facing surface section of a respective one of the at least one upper flow guidance parts in the or each station, an equalised laminar flow is established before the liquid reaches the exposed major surface of the substrate to be treated.

In an embodiment, the system for directing a respective stream of liquid onto the upper outward-facing surface section of a respective one of the at least one upper flow guidance parts is configured to direct a downwardly-directed stream of liquid onto the upper outward-facing surface section.

In an embodiment of the apparatus, the system for directing a respective stream of liquid onto the upper outward-facing surface section of a respective one of the at least one upper flow guidance parts is configured to direct a downwardly-directed stream of liquid onto the upper outward-facing surface section.

The stream may be downwardly-directed at the point along the trajectory of the stream at which the stream impinges on the upper outward-facing surface section, but upwardly-directed or horizontally-directed further upstream. By impinging at an acute angle, the flow will be less turbulent.

In an embodiment of the apparatus, the system for directing a respective stream of liquid onto the upper outward-facing surface section of a respective one of the at least one upper flow guidance parts comprises:
at least one flooding device,
wherein each flooding device comprises a vessel for holding liquid,
wherein the vessel is provided with at least one discharge passage through a side wall of the vessel, each defining a respective inflow aperture open to an interior of the vessel,
the flooding device being provided with at least one orifice in an exterior of the flooding device, for delivering liquid passing through at least one of the discharge passages as the stream; and
a liquid supply system for supplying liquid to the interior of the vessel of each flooding device,
wherein the system is configured to maintain a level of a free surface of liquid in the vessel of each flooding device at a level between the at least one discharge passage inflow apertures and a highest level of the vessel interior.

The flooding device comprises a vessel for holding liquid. In use, the liquid is present in the interior, which is generally bounded by at least a bottom wall and a side wall. Thus, it is possible to determine a level, namely with respect to the bottom wall. The vessel may be covered or closed at the top. The vessel interior may be vented. The vessel is provided with at least one discharge passage through a side wall of the vessel. The discharge passage may be a simple aperture or be defined by a conduit extending through the side wall, for example. The or each discharge passage defines a respective inflow aperture open to an interior of the vessel, through which liquid can flow into the discharge passage from the interior of the vessel, in use.

The flooding device is provided with at least one orifice in an exterior of the device. This orifice may be defined by the discharge passage where the discharge passage terminates at an opposite end to the inflow aperture. In other embodiments, the discharge passage merely communicates with the orifice, e.g. via intermediary flow conducting parts. The stream is a free-flowing stream. That is to say that the stream is unguided from the point where the stream leaves the orifice.

The flooding device is provided with at least one delivery port opening into the interior of the vessel and in liquid communication with at least one connection device for connecting the device to a supply conduit for supplying liquid to the device. The connection device may be a fitting, for example, or a hose or pipe end that can be connected to a fitting. The liquid will generally be pumped into the flooding device by a pump external to the flooding device.

The system is configured to maintain a level of a free surface of liquid in the vessel of each flooding device at a level between the at least one discharge passage inflow apertures and a highest level of the vessel interior. The pressure with which the liquid flows through the discharge passage or passages and then the orifice is thus the hydrostatic pressure. There is no back pressure, as when a spray bar is used. The pressure with which the liquid is supplied is immaterial. The stream of liquid is gravity-driven. The stream emerges from the orifice as a jet with a substantially constant velocity, determined only by the level of the liquid in the vessel interior (neglecting viscosity and streamline contraction), in accordance with Toricelli's law. The direction in which the opening points is immaterial, as is the density of the liquid.

The stream emerges from the orifice as a jet taking a parabolic path. Thus, the stream will impinge on the upper outward-facing surface section of the substrate holding device whilst on a downward trajectory. This reduces the amount of turbulence in the flow running along the surface of the substrate. Furthermore, because the velocity and direction are invariant, it is possible to optimise the dimensions of the upper outward-facing surface section, as well as the distance between that surface section and the orifice, to ensure that an equalised film flow over the substrate is always established.

In an example of this embodiment, at least one of the at least one flooding devices is provided with at least one overflow port opening into the interior of the vessel at a level between the at least one discharge passage inflow apertures and a highest level of the vessel interior, for conducting liquid out of the vessel.

The flooding device comprises at least one overflow port opening into the interior of the vessel at a level between the at least one discharge passage inflow apertures and a highest level of the vessel interior. This overflow port or these overflow ports are configured to conduct liquid out of the vessel, more particularly out of the vessel interior. By supplying liquid at a sufficient rate, the level of liquid in the vessel is maintained and determined by the level of the overflow ports, or at least the overflow port at the lowest level. Because this level is below a highest level of the vessel interior, there is a free surface of the liquid in the vessel interior.

Because the level of the free liquid surface in the vessel interior is determined by the overflow port location(s), there is no need to control the level by means of sensors and a controller configured to control the supply of liquid. This makes the device relatively robust, useful in applications in which the processing liquid is relatively aggressive. Furthermore, a supply pump can be run at substantially one single operating point, instead of being operated intermittently.

In an example of any embodiment in which at least one of the at least one flooding devices is provided with at least one overflow port opening into the interior of the vessel at a level between the at least one discharge passage inflow apertures and a highest level of the vessel interior, for conducting liquid out of the vessel, the discharge passages are more than one in number in at least one of the at least one flooding devices.

An effect is that the side wall sections through which the discharge passages extend remain relatively strong, as compared to providing one discharge passage with a large extent and/or cross-sectional area. The respective inflow apertures may be provided in a row, e.g. a row at a generally constant level. The inflow apertures and/or the discharge passages may have corresponding shapes and dimensions. In a particular example, the vessel interior has a multilateral, e.g. quadrilateral shape, seen from the top, and the inflow apertures are arranged in a row extending over a majority of a dimension of one side. The spacing between the apertures (in the direction in which the row extends) may be smaller than the corresponding dimension (i.e. the dimension in the same direction) of the inflow apertures. All this contributes to reducing the effect of streamline contraction, so that the velocity with which the liquid emerges is more accurately determined by only the level of the liquid in the vessel.

In an example of any embodiment in which at least one of the at least one flooding devices is provided with at least one overflow port opening into the interior of the vessel at a level between the at least one discharge passage inflow apertures and a highest level of the vessel interior, for conducting liquid out of the vessel, the orifice of at least one of the at least one flooding devices is formed by a slit.

The stream of liquid will therefore be sheet- or film-shaped. The liquid can impinge on the substrate holding device and flow down a major surface of the substrate in a film that is relatively uniform over the width of the planar substrate. The film will have substantially uniform thickness and velocity across the width of the substrate. Furthermore, a slit has a relatively small height, so that the velocity is generally constant over the height of the orifice. The orifice is formed where the slit emerges from an exterior surface of the device.

In an example of any embodiment in which at least one of the at least one flooding devices is provided with at least one overflow port opening into the interior of the vessel at a level between the at least one discharge passage inflow apertures and a highest level of the vessel interior, for conducting liquid out of the vessel, the discharge passages are more than one in number in at least one of the at least one flooding devices and the orifice of at least one of these at least one flooding devices is formed by a slit, the discharge passages define respective outflow apertures at opposite ends of the discharge passages to the respective inflow apertures, and the flooding device comprises a channel extending in parallel to the slit and in liquid communication with the slit, the outflow apertures opening into the channel.

The channel contributes to flow equalisation so that the stream of liquid has a relatively uniform velocity across the width of the slit.

In an example of any embodiment in which at least one of the at least one flooding devices is provided with at least one overflow port opening into the interior of the vessel at a level between the at least one discharge passage inflow apertures and a highest level of the vessel interior, for conducting liquid out of the vessel, and the orifice of at least one of the at least one flooding devices is formed by a slit, the discharge passages define respective outflow apertures at opposite ends of the discharge passages to the respective inflow apertures, the flooding device comprises at least a first masking part, distinct from the vessel and mounted to an exterior of the vessel in front of the outflow apertures, and the slit is defined between the first masking part and one of a second masking part mounted to the exterior of the vessel and a projecting part of the vessel.

It is an object to provide the stream as a relatively thin sheet or film of liquid. Thus, the slit should have a relatively small height. For uniformity, the height should be relatively well-defined over the entire width of the slit. This is achievable by defining the slit between a first masking part mounted to an exterior of the vessel and either a second masking part or an integral projecting part of the vessel. The height can be set by means of a gauge having a dimension corresponding to the intended height of the slit. The first masking part is placed against the gauge and then fixed to the vessel. The gauge is subsequently removed to open the slit. This requires a good-quality surface on the first masking part and the counterpart (second masking part or projecting part), but is more easily achievable than when the slit is machined in a solid part. It is also easier to provide the orifice with a relatively sharp edge that ensures that the stream of liquid flows along a parabolic trajectory.

In an example of any embodiment in which at least one of the at least one flooding devices is provided with at least one overflow port opening into the interior of the vessel at a level between the at least one discharge passage inflow apertures and a highest level of the vessel interior, for conducting liquid out of the vessel, and the orifice of at least one of the at least one flooding devices is formed by a slit, the discharge passages define respective outflow apertures at opposite ends of the discharge passages to the respective inflow apertures, the flooding device comprises at least a first masking part, distinct from the vessel and mounted to an exterior of the vessel in front of the outflow apertures, the slit is defined between the first masking part and one of a second masking part mounted to the exterior of the vessel and a projecting part of the vessel and the flooding device comprises a channel extending in parallel to the slit and in liquid communication with the slit, the outflow apertures opening into the channel, the channel is formed between the exterior of the vessel and at least the first masking part.

This allows for relatively easy manufacturing, since the channel can be defined by e.g. a groove in the vessel exterior and/or a chamfer on the first and/or second masking part. In other words, channel side wall can be machined in an exposed exterior surface of a component part of the device, then closed by assembling the component parts.

In an example of any embodiment in which at least one of the at least one flooding devices is provided with at least one overflow port opening into the interior of the vessel at a level between the at least one discharge passage inflow apertures and a highest level of the vessel interior, for conducting liquid out of the vessel, and the orifice of at least one of the at least one flooding devices is formed by a slit, the slit has a height, a width and a depth, seen from an outside of the device, and the width decreases with increasing depth from the orifice in the direction of the vessel.

Thus, to an observer moving through the slit in the direction of the vessel, the slit appears to have a decreasing lateral dimension, i.e. a decreasing width. An effect is to produce a sheet- or film-shaped stream of liquid emerging as a jet from the orifice that does not contract laterally. This increases the uniformity of the flow of the stream of liquid.

In an example of any embodiment in which at least one of the at least one flooding devices is provided with at least one overflow port opening into the interior of the vessel at a level between the at least one discharge passage inflow apertures and a highest level of the vessel, the at least one overflow ports comprise at least one overflow port extending through a side wall of the vessel.

The bottom of the processing station of the apparatus will generally comprise a basin or sump in which the processing liquid that has flowed down across the major surface of the substrate is collected. The liquid that exits the overflow port extending through the side wall of the vessel will drop into the basin. A recirculation system may be used to supply the collected liquid back to the device. For many applications, it is useful to aerate the processing liquid. The type of recirculation just described is suitable for this. Furthermore, it is possible to provide relatively many and/or relatively large overflow ports when they extend through a side wall of the vessel.

In an example of the previous embodiment, at least one, e.g. all, of the at least one overflow ports extending through a side wall of the vessel are provided on an opposite side of the vessel to the at least one discharge passages.

This ensures that the overflowing liquid is kept well-separated from the stream of liquid to be used for wetting the substrate.

In an example of any embodiment in which at least one of the at least one flooding devices is provided with at least one overflow port opening into the interior of the vessel at a level between the at least one discharge passage inflow apertures and a highest level of the vessel, and the at least one overflow ports comprise at least one overflow port extending through a side wall of the vessel, the flooding device comprising at least one overflow port extending through a side wall of the vessel further comprises at least one flow guide on an exterior of the vessel, wherein the flow guide is provided with a slanted surface section below an exterior orifice of at least one of the at least one overflow ports extending through a side wall of the vessel, the slanted surface section extending to an exterior surface in which the exterior orifice is defined and being angled such that a lower end of the slanted surface section is distal to the exterior surface in which the exterior orifice is defined.

This ensures that the overflow liquid is conducted away from the flooding device and also away from the substrate. The overflow liquid may be directed onto a side wall of the processing station of the apparatus for non-immersive wet-chemical treatment of the substrate. This allows the flooding device to be provided relatively high up in the processing station without the overflowing liquid splashing or causing a spray when hitting the liquid being collected at the bottom of the processing station.

In an example of the previous embodiment, the slanted surface section transitions into finger-shaped surface sections, e.g. finger-shaped surface sections at an angle to the slanted surface section, at the lower end.

There is an empty gap between adjacent fingers, through which the liquid can flow. The fingers thus break up the flow of liquid. This allows for a higher amount of aeration of the overflowing processing liquid prior to collection and recirculation.

In an example of any embodiment in which at least one of the at least one flooding devices is provided with at least one overflow port opening into the interior of the vessel at a level between the at least one discharge passage inflow apertures and a highest level of the vessel, the at least one overflow ports comprise at least one overflow port extending through a side wall of the vessel, the flooding device further comprises at least one flow guide on an exterior of the vessel, wherein the flow guide is provided with a slanted surface section below an exterior orifice of at least one of the at least one overflow ports extending through a side wall of the vessel, the slanted surface section extending to an exterior surface in which the exterior orifice is defined and being angled such that a lower end of the slanted surface section is distal to the exterior surface in which the exterior orifice is defined, at least a section of the slanted surface section proximal to the exterior surface in which the exterior orifice is defined is bounded laterally by parts defining facing upright surface sections.

This further helps direct the overflowing liquid such that splashing is minimised.

In an example of any embodiment in which at least one of the at least one flooding devices is provided with at least one overflow port opening into the interior of the vessel at a level between the at least one discharge passage inflow apertures and a highest level of the vessel, the at least one overflow ports comprise at least one overflow port extending through a side wall of the vessel, the flooding device further comprises at least one flow guide on an exterior of the vessel, wherein the flow guide is provided with a slanted surface section below an exterior orifice of at least one of the at least one overflow ports extending through a side wall of the vessel, the slanted surface section extending to an exterior surface in which the exterior orifice is defined and being angled such that a lower end of the slanted surface section is distal to the exterior surface in which the exterior orifice is defined, the flow guide is a part distinct from the vessel and mounted to an exterior of the vessel.

This simplifies manufacturing. The flow guide may in particular be comprised of plate-shaped sections joined together, e.g. adhesively or by welding or soldering.

In an example of any embodiment in which at least one of the at least one flooding devices is provided with at least one overflow port opening into the interior of the vessel at a level between the at least one discharge passage inflow apertures and a highest level of the vessel, the at least one overflow port of at least one of the flooding devices comprises at least one overflow port defined in a conduit extending through at least part of the interior of the vessel, e.g. at least one overflow port opening into the interior in a direction facing away from a bottom of the interior of the vessel.

The conduit allows to collect the overflowing liquid for rapid recirculation and without contamination. Furthermore, it is possible to provide relatively many and/or relatively elongated overflow ports along the length of the conduit without substantially weakening the vessel. Also, the overflow ports in the conduit may face upwards.

In an example of any embodiment in which at least one of the at least one flooding devices is provided with at least one overflow port opening into the interior of the vessel at a level between the at least one discharge passage inflow apertures and a highest level of the vessel, the at least one overflow ports of at least one of the flooding devices includes at least one overflow port in liquid communication with a connection device for connection to a conduit for carrying liquid overflowing into the at least one overflow port away from the flooding device.

This allows for recirculation and a relatively high rate of removal of liquid out of the device. Coupled with a high supply rate, the level of the free surface of liquid in the vessel interior is thus relatively impervious to disturbances. The connection device may be a fitting or simply a pipe or hose end that can be coupled to a fitting or connector.

In an example of any embodiment of the apparatus in which the system for directing a respective stream of liquid onto the upper outward-facing surface section of a respective one of the at least one upper flow guidance parts comprises:
at least one flooding device,
wherein each flooding device comprises a vessel for holding liquid,
wherein the vessel is provided with at least one discharge passage through a side wall of the vessel, each defining a respective inflow aperture open to an interior of the vessel,
the flooding device being provided with at least one orifice in an exterior of the flooding device, for delivering liquid passing through at least one of the discharge passages as the stream; and
a liquid supply system for supplying liquid to the interior of the vessel of each flooding device,
wherein the system is configured to maintain a level of a free surface of liquid in the vessel of each flooding device at a level between the at least one discharge passage inflow apertures and a highest level of the vessel interior,
the at least one delivery port of at least one of the flooding devices comprises, e.g. consists of, at least one delivery port formed in a conduit extending through at least part of the interior of the vessel.

Thus, liquid can enter the vessel interior over e.g. an extent of the vessel interior in one dimension. This is of use in ensuring a uniform level of liquid in the vessel interior. Furthermore, it is only necessary to pass one conduit through a side wall to supply liquid at a relatively high rate and low pressure.

In an example of any embodiment of the apparatus in which the system for directing a respective stream of liquid onto the upper outward-facing surface section of a respective one of the at least one upper flow guidance parts comprises:
at least one flooding device,
wherein each flooding device comprises a vessel for holding liquid,
wherein the vessel is provided with at least one discharge passage through a side wall of the vessel, each defining a respective inflow aperture open to an interior of the vessel,
the flooding device being provided with at least one orifice in an exterior of the flooding device, for delivering liquid passing through at least one of the discharge passages as the stream; and
a liquid supply system for supplying liquid to the interior of the vessel of each flooding device,
wherein the system is configured to maintain a level of a free surface of liquid in the vessel of each flooding device at a level between the at least one discharge passage inflow apertures and a highest level of the vessel interior,
the vessel of at least one of the flooding devices comprises a single body defining at least a wall bounding the interior of the vessel at least at a bottom and on all sides.

The single body can be an integral body made in one piece. The body may be moulded and/or machined. The body may be made of metal, polymer material or a composite. Joints formed by bonding are largely avoided, so that the risk of unintended leakage is minimised. The wall need not bound the interior of the vessel completely. There may be apertures that are closed by stops or covers separate from the body, for example. In another embodiment, the wall of the vessel interior where the wall bounds the vessel interior is completely comprised in the body.

In an example of this embodiment, the body leaves the interior of the vessel at least partly open at a top.

This makes manufacturing easier. Furthermore, the vessel interior need not be hermetically sealed.

In an example of any embodiment in which the body leaves the interior of the vessel at least partly open at a top, the body partly bounds the interior of the vessel at the top, at least one, e.g. a plurality of apertures being defined in the part of the body partly bounding the interior of the vessel at the top.

Thus, the parts of the top wall in which the apertures are defined serve as strengthening struts to make the vessel more rigid and thus shape-stable.

In an example of any embodiment in which the vessel of at least one of the flooding devices comprises a single body defining at least a wall bounding the interior of the vessel at least at a bottom and on all sides, at least one of the flooding devices of which the vessel comprises a single body comprises at least one cover, mounted to the body and closing the interior of the vessel at the top.

The cover helps prevent contamination of liquid in the vessel interior.

In an example of any embodiment of the apparatus in which the system for directing a respective stream of liquid onto the upper outward-facing surface section of a respective one of the at least one upper flow guidance parts comprises:
at least one flooding device,
wherein each flooding device comprises a vessel for holding liquid,
wherein the vessel is provided with at least one discharge passage through a side wall of the vessel, each defining a respective inflow aperture open to an interior of the vessel,
the flooding device being provided with at least one orifice in an exterior of the flooding device, for delivering liquid passing through at least one of the discharge passages as the stream; and
a liquid supply system for supplying liquid to the interior of the vessel of each flooding device,
wherein the system is configured to maintain a level of a free surface of liquid in the vessel of each flooding device at a level between the at least one discharge passage inflow apertures and a highest level of the vessel interior,
at least the interior of the vessel of at least one of the flooding devices has an elongated shape, seen from above, and
at least one, e.g. all, of the discharge passages extend through the side wall on a longer side of the interior of the vessel.

This is useful for wetting relatively wide substrates relatively uniformly. The elongated shape may be a multilateral, e.g. quadrilateral, shape, for example.

In an example of any embodiment of the apparatus in which the system for directing a respective stream of liquid onto the upper outward-facing surface section of a respective one of the at least one upper flow guidance parts comprises:
at least one flooding device,
wherein each flooding device comprises a vessel for holding liquid,
wherein the vessel is provided with at least one discharge passage through a side wall of the vessel, each defining a respective inflow aperture open to an interior of the vessel,
the flooding device being provided with at least one orifice in an exterior of the flooding device, for delivering liquid passing through at least one of the discharge passages as the stream; and
a liquid supply system for supplying liquid to the interior of the vessel of each flooding device,
wherein the system is configured to maintain a level of a free surface of liquid in the vessel of each flooding device at a level between the at least one discharge passage inflow apertures and a highest level of the vessel interior,
at least one of the at least one overflow ports of at least one of the flooding devices is elongated in shape, a width being greater than a height, seen in a direction of flow.

This allows for a relatively large rate of flow of overflowing liquid. A lower edge will generally be at one level, corresponding to the intended level of the free surface of the liquid in the vessel interior.

In an example of any embodiment of the apparatus in which the system for directing a respective stream of liquid onto the upper outward-facing surface section of a respective one of the at least one upper flow guidance parts comprises:
at least one flooding device,
wherein each flooding device comprises a vessel for holding liquid,
wherein the vessel is provided with at least one discharge passage through a side wall of the vessel, each defining a respective inflow aperture open to an interior of the vessel,
the flooding device being provided with at least one orifice in an exterior of the flooding device, for delivering liquid passing through at least one of the discharge passages as the stream; and
a liquid supply system for supplying liquid to the interior of the vessel of each flooding device,
wherein the system is configured to maintain a level of a free surface of liquid in the vessel of each flooding device at a level between the at least one discharge passage inflow apertures and a highest level of the vessel interior,
the at least one inflow apertures of at least one of the flooding devices are located at a bottom of the interior of the vessel.

The inflow apertures may thus have a lower edge or lowest point of the edge at the level of the bottom of the interior of the vessel. This allows for emptying of the device for maintenance or the like. In use, stagnant volumes of processing liquid are essentially avoided. Furthermore, because gases rise to the top, the risk of bubbles in the processing liquid flowing through the discharge passages is kept relatively low.

According to another aspect, the method of non-immersive wet-chemical treatment of a planar substrate according to the invention comprises:
mounting the substrate to a device according to the invention, and
directing a respective stream of liquid onto the upper outward-facing surface section of a respective one of the at least one upper flow guidance parts.

The method results in a relatively uniform equalised film flow down the exposed region of a major surface of the substrate.

In an embodiment, a downwardly-directed stream of liquid is directed onto the upper outward-facing surface section.

There is thus no or little flow of liquid upwards over the upper outward-facing surface section. There are thus also few or no eddies.

The stream of liquid may be directed onto the upper outward-facing surface section of the upper flow guidance part at a sufficient distance from the lower edge to establish a laminar film flow at the lower edge.

The method may be carried out in an apparatus according to the invention. Similarly, the device and apparatus of the invention are suitable for carrying out the method.

### Brief Description of Drawings

The invention will be explained in further detail with reference to the accompanying drawings, in which:
- Fig. 1: is a cross-sectional view of part of a treatment station of an apparatus for non-immersive wet-chemical treatment of a planar substrate;
- Fig. 2: is a perspective view of one of two flooding devices present in the part of the station shown in Fig. 1;
- Fig. 3: is a second perspective view of the flooding device of Fig. 2;
- Fig. 4: is a top plan view of the flooding device of Figs. 2 and 3, with a cover removed;
- Fig. 5: is a cross-sectional view of the flooding device along the line A-A in Fig. 4;
- Fig. 6: is a side plan view of the flooding device of Figs. 2-5;
- Fig. 7: is a cross-sectional view of the flooding device along the line B-B in Fig. 6;
- Fig. 8: is a perspective view of a body forming a vessel in the flooding device of Figs. 2-7;
- Fig. 9: is a perspective view of an upper masking part of the flooding device of Figs. 2-8;
- Fig. 10: is a front plan view of the upper masking part of Fig. 9;
- Fig. 11: is a cross-sectional view of the upper masking part of Figs. 9 and 10;
- Fig. 12: is a perspective view of a lower masking part of the flooding device of Figs. 2-11;
- Fig. 13: is a front plan view of the lower masking part of Fig. 12;
- Fig. 14: is a cross-sectional view of the lower masking part of Figs. 12 and 13;
- Fig. 15: is a perspective view of a substrate holding device for use in the apparatus of Fig. 1;
- Fig. 16: is a front plan view of the substrate holding device of Fig. 15;
- Fig. 17: is a cross-sectional view along the line A-A in Fig. 16;
- Fig. 18: is a perspective view of a first upper flow guidance part comprised in the substrate holding device of Figs. 15-17;
- Fig. 19: is a cross-sectional view of the first upper flow guidance part of Fig. 18;
- Fig. 20: is a detailed cross-sectional view of part of the first upper flow guidance part of Figs. 18 and 19;
- Fig. 21: is a perspective view of a second upper flow guidance part comprised in the substrate holding device of Figs. 15-17;
- Fig. 22: is a front plan view of the second upper flow guidance part of Fig. 21;
- Fig. 23: is a cross-sectional view of the second upper flow guidance part of Figs. 21 and 22;
- Fig. 24: is a detailed cross-sectional view of part of the second upper flow guidance part of Figs. 21-23;
- Fig. 25: is a cross-sectional view of parts of the first and second upper flow guidance parts of Figs. 18-24 as mounted in the substrate holding device of Figs. 15-24;
- Fig. 26: is a perspective view of one of two identically-shaped lower flow guidance parts comprised in the substrate holding device of Figs. 15-24;
- Fig. 27: is a cross-sectional view of the lower flow guidance part of Fig. 26;
- Fig. 28: is a detailed cross-sectional view of part of the lower flow guidance part of Figs. 26 and 27; and
- Fig. 29: is a side plan view of two lower flow guidance parts as shown in Figs. 26-28 as mounted in the substrate holding device of Figs. 15-24.

### Description of Embodiments

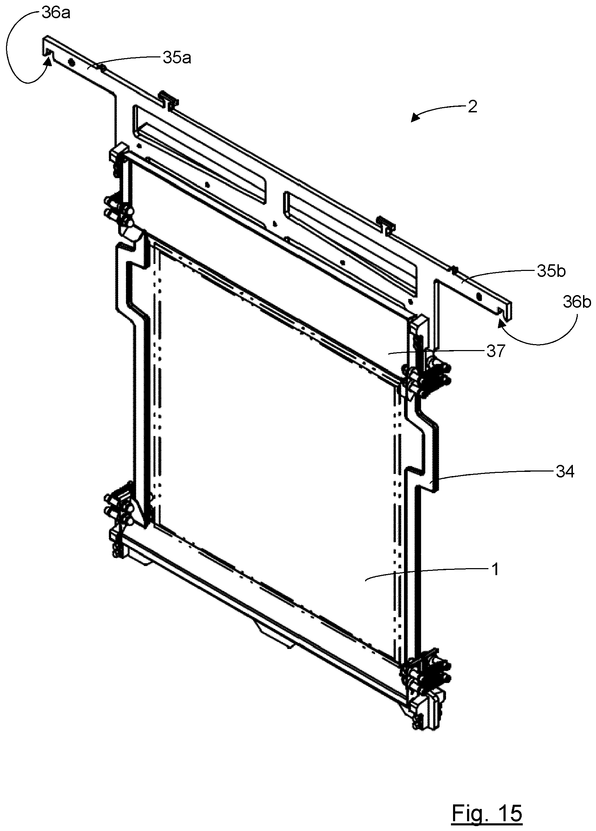

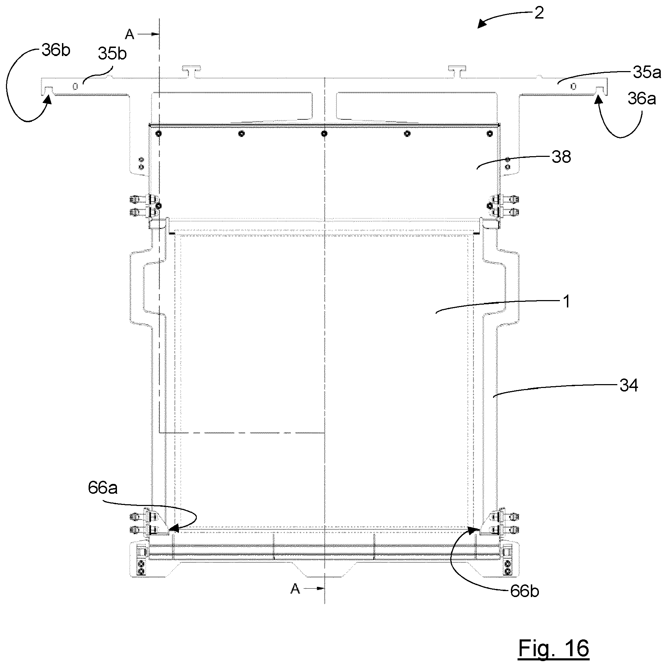

In the following, an embodiment of an apparatus for non-immersive wet-chemical treatment of a planar substrate 1 (Figs. 15-17) will be described. Instead of being immersed in a bath of processing liquid, the substrate 1 is wetted on at least one side by processing liquid that flows across a major surface of the substrate 1 on that side in the form of a relatively thin film. This reduces the amount of processing liquid that is needed, providing environmental and economic benefits. The treatment may comprise rinsing, de-smearing, etching, swelling, reduction or plating, including electrodeless plating, for example. Indeed, the apparatus may comprise multiple treatment stations, each configured in the manner to be described in more detail, but with the processing liquid differing between at least two of the stations.

Although the substrate 1 is referred to as planar, the substrate may be flexible, e.g. a foil. The apparatus is suitable in particular for such substrates as printed circuit boards, semiconductor dies or integrated circuits substrates and the like.

In the illustrated embodiment, the apparatus is arranged to treat both major surfaces of the substrate 1 by wetting them with processing liquid that flows down the surface as an equalised thin film flow over substantially the entire width of the major surface concerned. To this end, the substrate 1 is held in a substrate holding device 2 to be described in more detail below. Processing liquid is directed onto the substrate holding device 2 from either side in the form of respective streams of liquid. The streams are sheet-shaped and follow a parabolic trajectory intersecting the surface of the substrate holding device at an acute angle. A laminar flow is established before the liquid flows onto the major surface of the substrate 1.

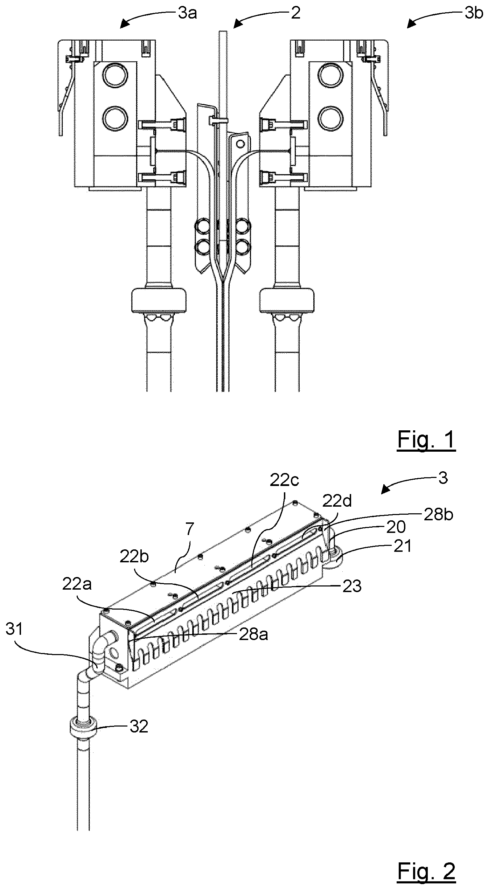

Since both major surfaces of the substrate 1 are treated, the apparatus comprises two flooding devices 3a,b (Fig. 1) for delivering the streams of liquid. The flooding devices 3a,b are identical, so that only one is described and shown in detail.

The flooding device 3 comprises a body 4 (Figs.2-8) forming a vessel 5 for holding liquid. In the illustrated embodiment, the body 4 is made in one piece, albeit surface treatment, including coating and anodising, are possible. The body 4 may be moulded or machined and made of metal or polymer material, including polymer composite material. The body 4 defines a vessel interior for holding the liquid, which is bounded by a bottom wall and a side wall. The side wall is quadrilateral, seen from the top, where the side wall bounds the vessel interior. Otherwise, both the vessel interior and the body 4 have an elongated shape, seen from the top.

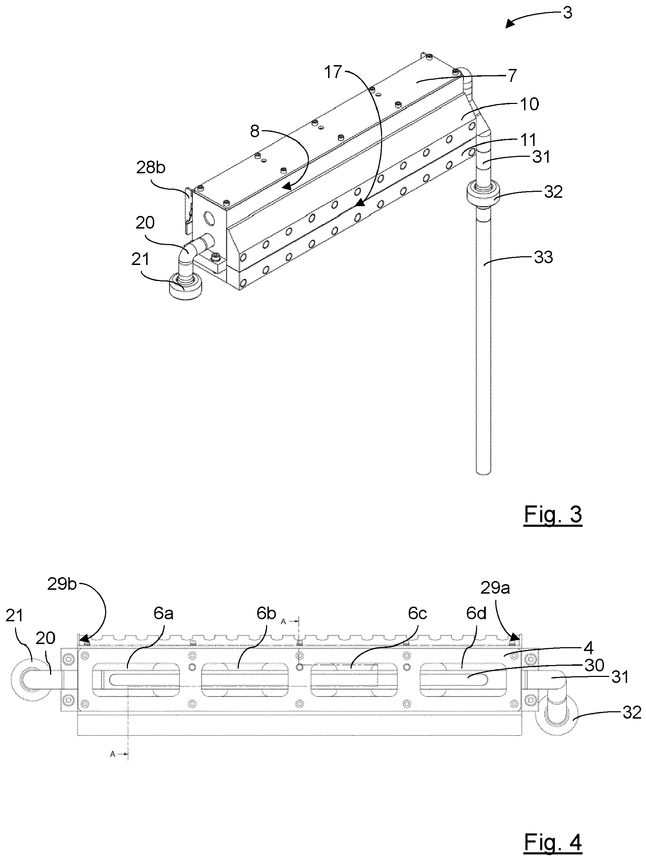

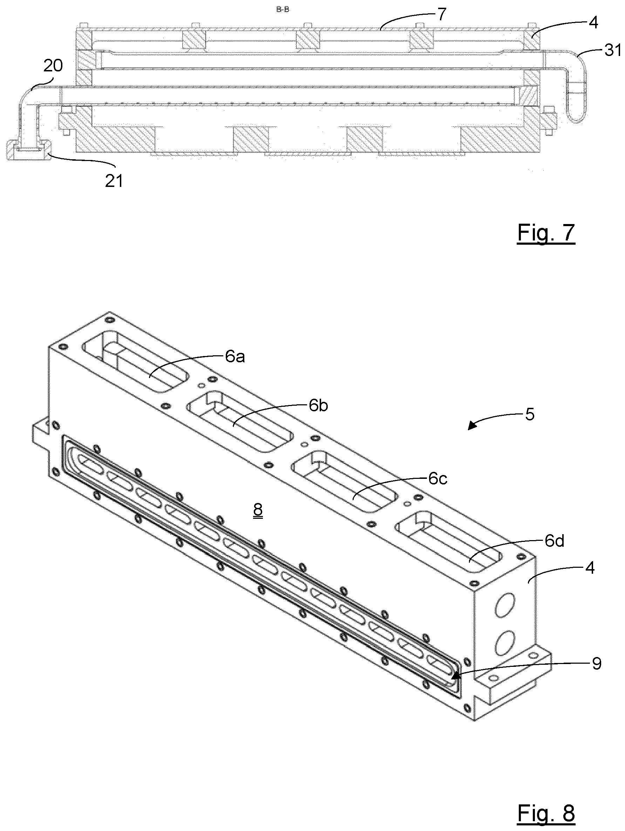

In the illustrated embodiment, the body 4 has a top wall comprising four elongated apertures 6a-d (Figs. 4 and 8). The top wall bounds the vessel interior at the top. The body 4 thus leaves the vessel interior partly open at the top. A cover 7 is mounted to the body 4 to cover the apertures 6a-d. In the illustrated embodiment, the cover 7 is fixed to the body 4 by screws. Other types of fastener or other types of attachment are conceivable, e.g. reversible snaplock connections.

A row of discharge passages through the side wall of the vessel defined by the body 4 defines a respective row of inflow apertures open to an interior of the vessel 5. At the other end, the discharges passages define a row of outflow apertures in an exterior surface 8 of the body 4. The outflow apertures are set back with respect to a flat major part of the exterior surface 8 being arranged in an elongated recess 9 extending in row direction. The discharge passages, inflow apertures and outflow apertures have an elongated cross-section (transverse to the direction of flow). Their width is greater than their height. In the illustrated embodiment, the discharge passages, inflow apertures and outflow apertures have an elongated cross-section with a width greater than that of the wall sections separating adjacent discharge passages. In the illustrated embodiment, the cross-section is constant and the discharge passages are straight. The elongated recess has a length equal to at least 90 % of the corresponding dimension of the vessel interior. Each of these characteristics contributes to establishing relatively uniform flow through the wall of the body 4 forming the vessel 5.

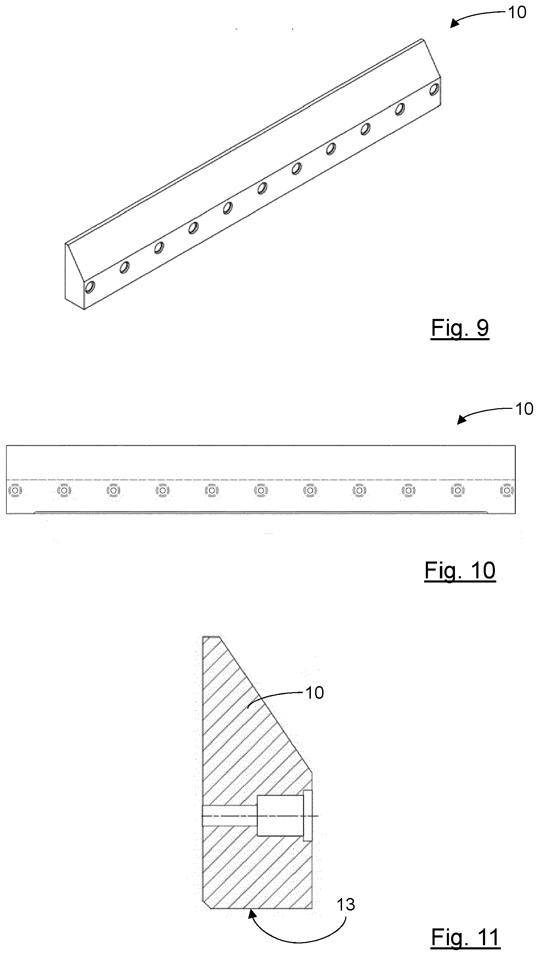

The illustrated flooding device 3 comprises an upper masking part 10 (Figs. 9-11) and a lower masking part 11 (Figs. 10-14). The upper masking part 10 and the lower masking part 11 are each mounted against the exterior surface 8 of the body 4. The upper masking part 10 and lower masking part 11 are mounted in front of the outflow apertures of the discharge passages. Mounting may be by means of screws or other fasteners.

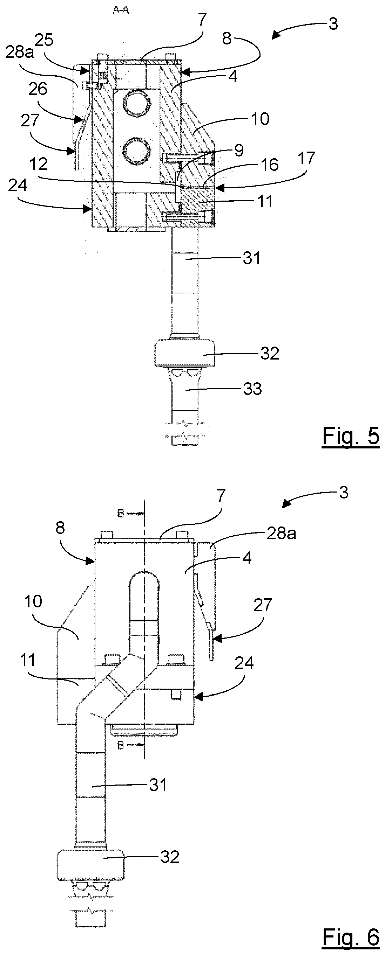

The upper masking part 10, the lower masking part 11 and the elongated recess 9 together define an equalising channel 12 (Fig. 5) into which the outflow apertures of the discharge passages open. This equalising channel 12 is elongated and closed at the longitudinal ends.

The upper masking part 10 has, in the illustrated embodiment, a flat lower surface 13, but for a recess along an edge proximal to the body 4, which recess partly defines the equalising channel 12. The opposite edge of the lower surface 13 is relatively sharp.

The lower masking part 11 has an upper surface in which a flat central section 14 is set back with respect to adjacent flat lateral end sections 15a,b. The flat central section 14 and the lower surface 13 of the upper masking part 10 between them define a slit 16 (Fig. 5) forming an orifice 17 from which, in use a sheet-shaped stream of liquid is discharged.

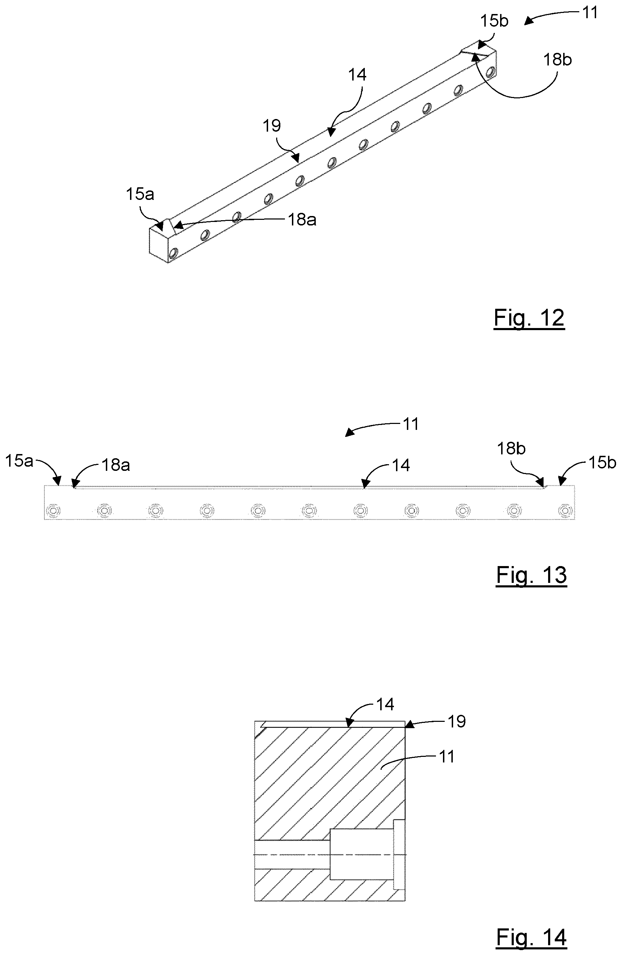

Seen from the outside, the slit 16 has a height, a width and a depth. The height may have a value in the range of 0.5 - 1.5 mm, e.g. in the range of 0.6 - 1.3 mm. The depth may have a value of at least 10 mm, e.g. at least 25 mm. This contributes to ensuring that the stream of liquid emerging from the orifice 17 is generally horizontally directed on leaving the orifice 17. The maximum value is less important, but may at most 50 mm. The width decreases from the orifice 17 in the direction of the body 4 forming the vessel. Lateral edges 18a,b (Fig. 12) of the central section 14 of the upper surface extend at an angle to a straight front edge 19, e.g. an angle in the range of 20-40°. This helps prevent the sheet-shaped stream of liquid emerging from the orifice 17 from contracting laterally. The front edge 19 is relatively sharp to ensure that a well-defined jet of liquid emerges from the orifice 17.

The height of the slit 16 can be set relatively exactly by placing a gauge between the upper masking part 10 and the lower masking part 11 when mounting them to the body 4. After fixing the upper masking part 10 and the lower masking part 11 in place, the gauge is removed to open up the slit 16.

In use, liquid is supplied to the flooding device 3 by a pump (not shown) through a supply pipe (not shown) connected to a supply conduit 20 via a fitting 21 (Figs. 3, 4, 7). The supply conduit 20 passes through a side wall at a longitudinal end of the body 4 into the vessel interior and extends over substantially the entire extent of the vessel interior to the opposite longitudinal end. The supply conduit 20 is closed at that end. One or more delivery ports are provided along the length of the section of the supply conduit 20 extending through the vessel interior. In the illustrated embodiment, these ports comprise relatively many small holes through an underside of the section of the supply conduit 20 extending through the vessel interior. The inflow apertures of the discharge passages are at a yet lower level, so that gas bubbles are unlikely to pass into the discharge passages.

The flooding device 3 is provided with a plurality of overflow ports opening into the interior of the vessel at a level between the level of the inflow apertures of the discharge passages and a highest level of the vessel interior. The latter level is the highest level a free surface of the liquid could reach in the absence of the overflow ports. This is generally determined by the upper edge of an interior surface of the side wall bounding the vessel interior.

The overflow ports include a plurality of sidewall overflow ports 22a-d (Fig. 2) extending through a side wall of the body 4 that forms the vessel 5. The sidewall overflow ports 22a-d are provided on an opposite side of the body 4 forming the vessel 5 to the discharge passages, and they are at a higher level.

In the illustrated embodiment, the sidewall overflow ports 22a-d are more than one in number and arranged in a row at a common level. The sidewall overflow ports 22a-d have an elongated cross-section with a larger width than their height, seen in the direction of flow. The lateral extent of the sections of the side wall separating adjacent sidewall overflow ports 22a-d is smaller than the width of any of the sidewall overflow ports 22a-d. Compared to providing one very wide slit-shaped overflow port, providing a plurality of them in a row results in a stronger side wall for a given wall thickness.

The flooding device 3 further comprises a flow guide 23 mounted against an exterior surface 24 of the body 4 forming the vessel 5. In the illustrated embodiment, the sidewall overflow ports 22a-d extend through both the side wall of the body 4 and a plate-shaped section of the flow guide 23. Exterior orifices of the sidewall overflow ports 22a-d are formed in the plate-shaped section of the flow guide 23. In other embodiments, the flow guide 23 may be located entirely at a lower level than the sidewall overflow ports 22.

The exterior orifices are defined in a surface section 25 (Fig. 5) that is generally parallel to the exterior surface 24. This parallel flow guide surface section 25 transitions into a slanted flow guide surface section 26. The slanted flow guide surface section 26 is angled such that a lower end is distal to the parallel flow guide surface section 25 in which the exterior orifices of the sidewall overflow ports 22a-d are defined.

The slanted flow guide surface section 26 transitions into finger-shaped surface sections 27 at a lower end of the slanted flow guide surface section 26. The finger-shaped surface sections 27 are bent, such that the distal ends of the fingers point downwards. The fingers are arranged in a row and spaced apart to allow the liquid flow to break up and thereby increase aeration.

Winglets 28a,b define upright surface sections 29a,b facing towards each other and laterally bounding the parallel flow guide surface section 25 and at least an upper section of the slanted flow guide surface section 26. These upright surface sections 29a,b guide the flow of liquid over the slanted flow guide surface section 26. The slanted flow guide surface section 26 carries overflowing processing liquid away from the flooding device 3 to a position that may be close enough to a side wall of the processing station of the treatment apparatus in which the flooding device 3 is comprised for the liquid to flow down along that side wall.

The overflow ports of the flooding device 3 further comprise an elongated overflow port 30 in an overflow conduit 31 extending through an interior of the body 4 forming the vessel 5. In the illustrated embodiment, the overflow conduit 31 extends through the interior in longitudinal direction from one end of the interior to the other. The elongated overflow port 30 is slightly shorter.

In the illustrated embodiment, the elongated overflow port 30 opens into the interior in a direction facing away from a bottom of the interior of the body 4 forming the vessel 5. The overflow conduit 31 extends through the side wall of the body 4 forming the vessel 5 to an overflow conduit fitting 32. This overflow conduit fitting 32 is connected to a return pipe 33 for returning processing liquid to a pump (not shown) or a reservoir from which the pump is arranged to pump processing liquid. One or more filters or sedimentation reservoirs may be interposed between the return pipe 33 and the pump.

In alternative embodiments, there may be more than one overflow port in the overflow conduit 31 instead of the single elongated overflow port 30. A hose may be used instead of the return pipe 33.

The stream of liquid emerging through the slit 16 defined between the upper and lower masking parts 10,11 will flow in the form of a curved sheet, the curve (i.e. the flow trajectory) being essentially parabolic in shape. The stream of liquid will emerge in an essentially horizontal direction. The velocity is determined by the hydrostatic pressure only. In use, the pump is arranged to supply liquid at a higher volumetric flow rate than can leave the flooding device 3 through the discharge passages at the flow rate dictated by the hydrostatic pressure. This ensures that there is always an overflow of processing liquid. The level of the free surface of liquid in the interior of the body 4 forming the vessel 5 is thereby determined relatively precisely and remains constant, even if there are variations in the rate at which liquid is supplied by the pump. The exit velocity through the orifice 17 defined by the slit 16 formed between the upper and lower masking parts 10,11 is therefore constant. The angle at which the stream of liquid impinges on the substrate holding device 2 is likewise constant.

The substrate holding device 2 comprises a support structure 34 (Figs. 15-17) in the form of a frame surrounding the substrate 1 on all sides, seen perpendicularly to the major surfaces of the substrate 1.

In the illustrated embodiment, the support structure 34 comprises laterally projecting arms 35a,b for engaging supports (not shown) so as to suspend the support structure 34 in the treatment station of the treatment apparatus. In the illustrated embodiment, claws 36a,b open in a downward direction are formed at the distal ends of the laterally projecting arms 35a,b. These claws 36a,b can engage horizontally extending pins (not shown) of the respective supports. Examples of such supports are disclosed in WO 2020/260389 A1.

In alternative embodiments, the support structure 34 may comprise hooks or similar devices for suspending the support structure 34 from an overhead conveyor, which then comprises a part forming a support for suspending the support structure 34 in the station of the treatment apparatus.

In the illustrated embodiment, the substrate holding device 2 comprises first and second upper flow guidance parts 37,38 and first and second lower flow guidance parts 39a,b. The first and second lower flow guidance parts 39a,b are identical, so that only one of them will be described.

In use, the substrate 1 is held in a plane by the substrate holding device 2. The substrate 1 occupies a region of the plane that is framed by the support structure 34. The upper flow guidance parts 37,38 are supported by the support structure 34 and located on opposite sides of the plane, as are the lower flow guidance parts 39a,b.

The first and second upper flow guidance parts 37,38 form the respective arms of an upper clamping device for clamping the substrate 1 close to an upper edge of the substrate 1. The lower flow guidance parts 39a,b form the respective arms of a lower clamping device for clamping the substrate 1 close to a lower edge of the substrate 1.

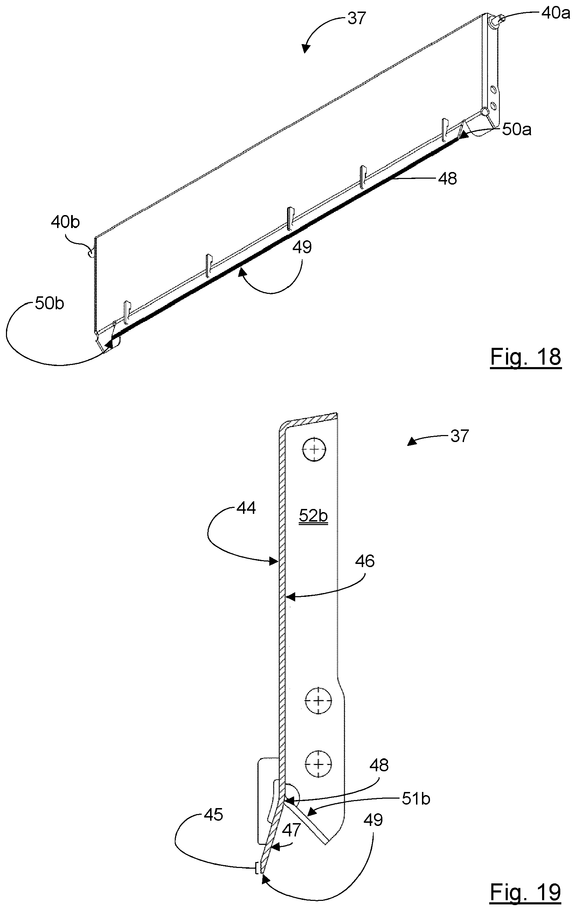

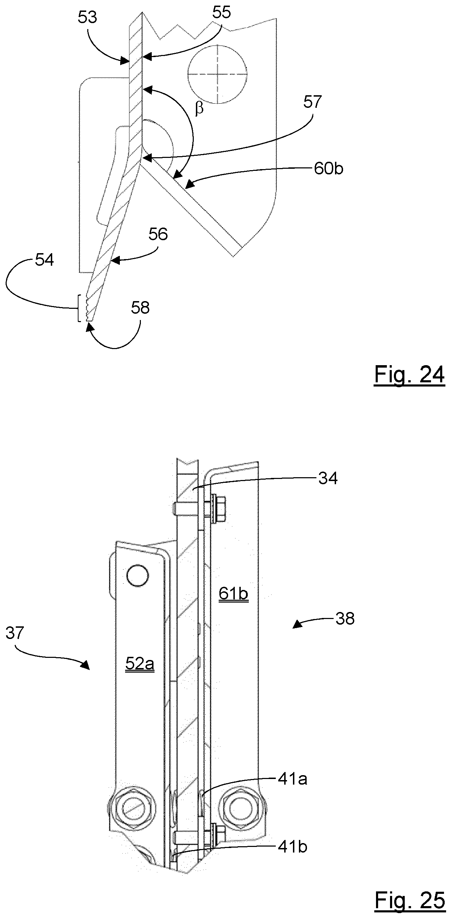

To this end, the first upper flow guidance part 37 is pivotably attached to the support structure 34 by means of projecting upper pivot stubs 40a,b (Fig. 18) defining a pivot axis parallel to the plane in which the substrate 1 is held. The upper pivot stubs 40a,b are received in holes (not shown in detail) in the support structure 34. Upper biasing devices 41a,b (Fig. 25) urge the first upper flow guidance part 37 towards the second upper flow guidance part 38 and exert a clamping force. In the illustrated embodiment, the upper biasing devices 41a,b are coil springs. They may comprise other types of elastic elements, gas springs or magnets in alternative embodiments.

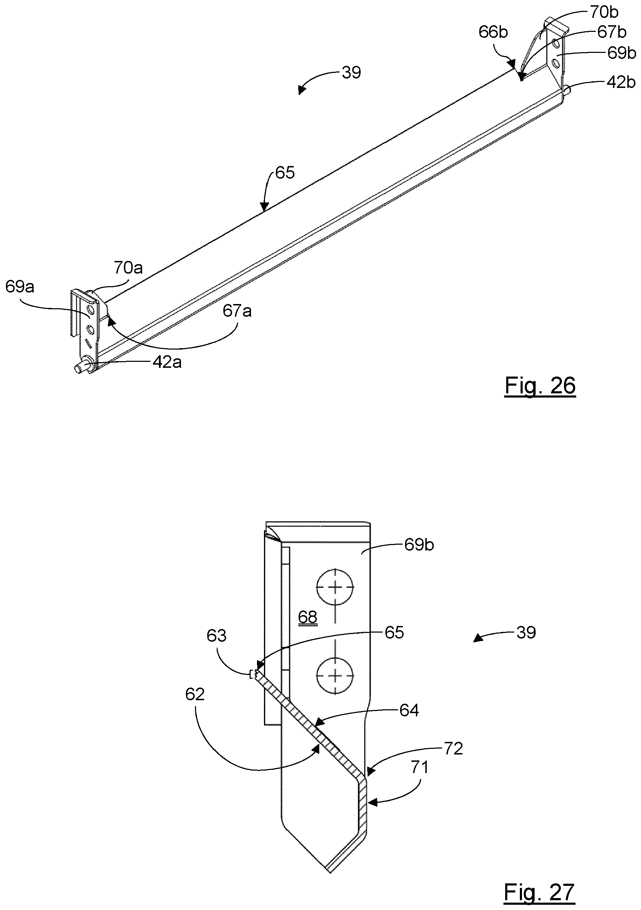

Each lower flow guidance part 39 is provided with projecting lower pivot stubs 42a,b (Fig. 26) for pivotable attachment to the support structure 34.

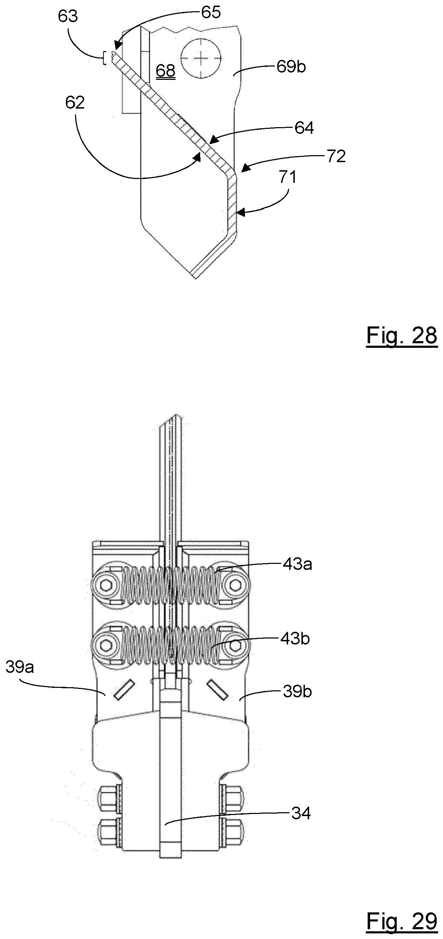

The projecting lower pivot stubs 42,b define a pivot axis parallel to the plane in which the substrate 1 is held. The lower pivot stubs 42,b are received in holes (not shown in detail) in the support structure 34. Lower biasing devices 43a,b (Fig. 29) urge the lower flow guidance parts 39a,b towards each other and exert a clamping force. In the illustrated embodiment, the lower biasing devices 43a,b are again coil springs. The may comprise other types of elastic elements, gas springs or magnets in alternative embodiments.

The first upper flow guidance part 37 has an inward-facing surface 44 facing inwards and an outward-facing surface facing outwards with respect to the plane in which the substrate 1 is arranged to be held, in use. The inward-facing surface 44 comprises a strip 45 for engaging a major surface of the substrate 1 without interruptions over the entire longitudinal extent of the strip 45. A remainder of the inward-facing surface 44 is spaced apart from that surface when the strip 45 contacts the (flat) major surface.

The strip 45 is provided with grooves or a similar surface structure for better engagement. In other words, the surface roughness of the strip 45 is higher than that of other parts of the inward-facing surface 44.

The outward-facing surface comprises an upper outward-facing surface section 46 onto which one of the flooding devices 3a,b is arranged to direct the stream of processing liquid. The upper outward-facing surface section 46 is flat. In use, the upper outward-facing surface section 46 is oriented substantially parallel to the plane in which the substrate 1 is arranged to be held. This means that the upper outward-facing surface section 46 is substantially vertically oriented, in use. The distance between the flooding device 3 and the first upper flow guidance part 37 is such that the stream of liquid impinges on the upper outward-facing surface section 46 at an acute angle from above.

A first lower outward-facing surface section 47 extends from a fold 48 forming a transition between a central part of the upper outward-facing surface section 46 to a lower edge 49. The first lower outward-facing surface section 47 is flat. The first lower outward-facing surface section 47 faces downwards, i.e. the lower edge 49 is closer to the plane in which the substrate 1 is held than the fold 48.

In the illustrated embodiment, the lower edge 49 is straight.

The lower edge 49 extends between lateral edges of the first lower outward-facing surface section 47, the lateral edges meeting the lower edge 49 at respective corners 50a,b of the first lower outward-facing surface section 47.

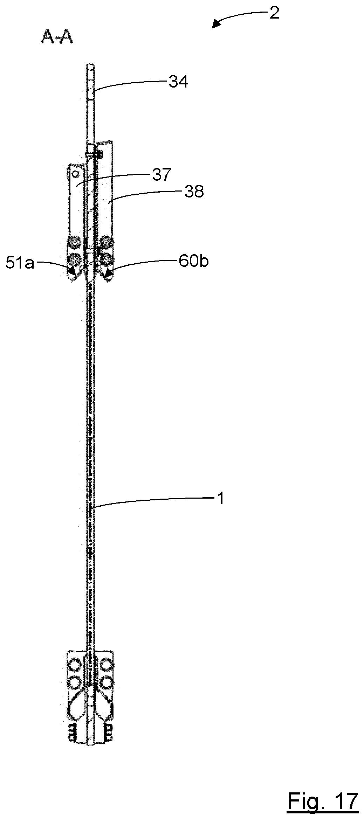

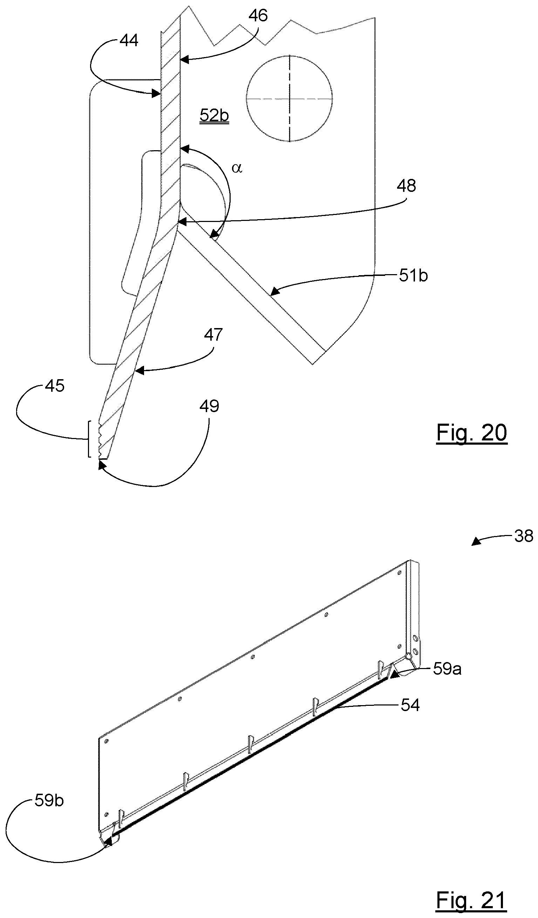

The outward-facing surface of the first upper flow guidance part 37 further comprises lateral lower outward-facing surface sections 51a,b (Figs. 17, 19, 20), separate from the first lower outward-facing surface section 47 and adjoining the upper outward-facing surface section 46. The transition is at the fold 48, but the lateral lower outward-facing surface sections 51a,b face upwards. Thus, each lateral lower outward-facing surface section 51a,b extends at an angle α (Fig. 20) smaller than 180° with respect to the upper outward-facing surface section 46. The lateral lower outward-facing surface sections 51a,b stiffen the first upper flow guidance part 37 and direct liquid away from the support structure 34.

The upper outward-facing surface section 46 is bounded laterally by facing surfaces 52a,b (Figs. 19, 20 , 25) facing towards each other and extending at an angle, e.g. transversely, to the plane in which the substrate is arranged to be held. The facing surfaces 52a,b direct the liquid onto the lower outward-facing surface section 47.

The second upper flow guidance part 38 (Figs. 21-25) has an inward-facing surface 53 facing inwards and an outward-facing surface facing outwards with respect to the plane in which the substrate 1 is arranged to be held, in use. The inward-facing surface 53 comprises a strip 54 for engaging a major surface of the substrate 1 without interruptions over the entire longitudinal extent of the strip 54. A remainder of the inward-facing surface 53 is spaced apart from that surface when the strip 54 contacts the (flat) major surface.

The strip 54 is provided with grooves or a similar surface structure for better engagement. In other words, the surface roughness of the strip 54 is higher than that of other parts of the inward-facing surface 53.

The outward-facing surface comprises an upper outward-facing surface section 55 onto which one of the flooding devices 3a,b is arranged to direct the stream of processing liquid. The upper outward-facing surface section 55 is flat. In use, the upper outward-facing surface section 55 is oriented substantially parallel to the plane in which the substrate 1 is arranged to be held. Thus, the upper outward-facing surface section 55 is substantially vertically oriented. The distance between the flooding device 3 and the second upper flow guidance part 38 is such that the stream of liquid impinges on the upper outward-facing surface section 55 at an acute angle from above.

A second lower outward-facing surface section 56 extends from a fold 57 forming a transition between a central part of the upper outward-facing surface section 55 to a lower edge 58. The second lower outward-facing surface section 56 is flat. The second lower outward-facing surface section 56 faces downwards, i.e. the lower edge 58 is closer to the plane in which the substrate 1 is held than the fold 57.

In the illustrated embodiment, the lower edge 58 is straight.

The lower edge 58 extends between lateral edges of the first lower outward-facing surface section 56, the lateral edges meeting the lower edge 58 at respective corners 59a,b of the first lower outward-facing surface section 56.

The outward-facing surface of the first upper flow guidance part 38 further comprises lateral lower outward-facing surface sections 60a,b, separate from the centrally positioned second lower outward-facing surface section 56 and adjoining the upper outward-facing surface section 55. The transition is at the fold 57, but the lateral lower outward-facing surface sections 60a,b face upwards. Thus, each lateral lower outward-facing surface section 60a extends at an angle β (Fig. 24) smaller than 180° to the upper outward-facing surface section 55. This angle β will generally be larger than 90° The lateral lower outward-facing surface sections 60a,b stiffen the second upper flow guidance part 38 and direct liquid away from the support structure 34.

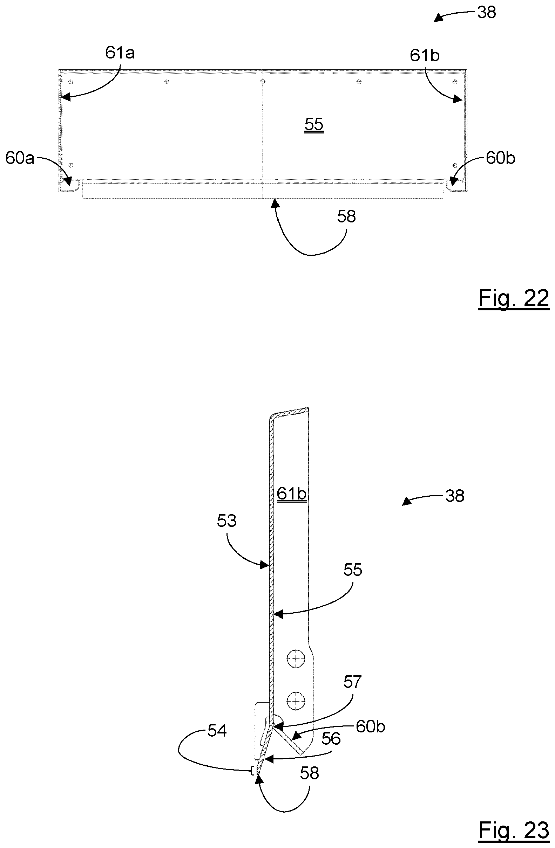

The upper outward-facing surface section 55 is bounded laterally by facing surfaces 61a,b (Fig. 22) facing towards each other and extending at an angle, e.g. transversely, to the plane in which the substrate is arranged to be held. The facing surfaces 61a,b direct the liquid onto the lower outward-facing surface sections 56,60a,b.

Each lower flow guidance part 39 (Fig. 26-29) has an inward-facing surface 62 facing inwards and an outward-facing surface facing outwards with respect to the plane in which the substrate 1 is arranged to be held, in use. The inward-facing surface 62 comprises an elongated strip 63 for engaging a major surface of the substrate 1 without interruptions over the entire longitudinal extent of the strip 63. A remainder of the inward-facing surface 62 is spaced apart from that surface of the substrate 1 when the strip 63 contacts the (flat) major surface.

The strip 63 is provided with grooves or a similar surface structure for better engagement. In other words, the surface roughness of the strip 63 is higher than that of other parts of the inward-facing surface 62.

The outward-facing surface comprises a slanting upper outward-facing surface section 64 extending to an upper edge 65 and slanting inwards towards the plane in which the substrate 1 is arranged to be held in the direction of the upper edge 65.

The slanting upper outward-facing surface section 64 is flat in the illustrated embodiment.

The strip 63 extends longitudinally along the upper edge 65 and transversely up to the upper edge 65.

The upper edge 65 extends between lateral edges of the first slanting upper outward-facing surface section 64, the lateral edges meeting the upper edge 65 at respective first corners 66a,b of the slanting upper outward-facing surface section 64.

The lateral edges extend from the first corners 66a,b to respective second corners 67a,b (Fig. 26), where the slanting upper outward-facing surface section 64 widens to increase the width of the slanting upper outward-facing surface section 64.

The wider part of the slanting upper outward-facing surface section 64 is bounded laterally by facing surfaces 68 (only one is visible in the drawings) facing towards each other and extending at an angle, e.g. transversely, to the plane in which the substrate 1 is arranged to be held. Plate-shaped segments 69a,b defining the facing surfaces 68 are interconnected to a plate-shaped segment defining the slanting upper outward-facing surface section 64 by respective webs 70a,b extending at an angle to both of them.

A lower outward-facing surface section 71 extends from a fold 72 forming a transition between the slanting upper outward-facing surface section 64 and the lower outward-facing surface section 71. The lower outward-facing surface section 71 is flat. The lower outward-facing surface section 71 is oriented generally parallel to the plane in which the substrate 1 is arranged to be held, in use. In any case, the slanting upper outward-facing surface section 64 and the lower outward-facing surface section 71 extend at an angle larger than 90° to each other. The lower outward-facing surface section 71 predominantly fulfils a shielding function for keeping liquid away from the support structure.

In use, the processing liquid is directed onto the upper outward-facing surface section 46,55 of one of the first and second upper flow guidance parts 37,38 and from there flows as an equalised film flow over the lower outward-facing surface section 47,56 onto the major surface of the substrate 1. The film flow then continued onto the slanting upper outward-facing surface section 64 of the lower flow guidance part 39 before dropping off the substrate holding device 2. The liquid is then collected for recirculation, optionally after filtering or another type of processing. Substantially the entire exposed region of the major surface of the substrate 1 is wetted in a relatively uniform manner.

The invention is not limited to the embodiments described above, which may be varied within the scope of the accompanying claims. For example, the second upper flow guidance part 38 may pivot with respect to the support structure 34 in the same way as the first upper flow guidance part 37 in an alternative embodiment.

### List of reference numerals

- 1: - Substrate
- 2: - Substrate holding device
- 3: - Flooding device
- 4: - Body
- 5: - Vessel
- 6a-d: - Top wall apertures
- 7: - Cover
- 8: - Front exterior surface
- 9: - Elongated recess
- 10: - Upper masking part
- 11: - Lower masking part
- 12: - Equalising channel
- 13: - Lower surface of upper masking part
- 14: - Central section of upper surface of lower masking part
- 15a,b: - Sections of upper surface of lower masking part at lateral ends
- 16: - Slit
- 17: - Orifice
- 18a,b: - Lateral edges of central section of upper surface of lower masking part
- 19: - Front edge of central section of upper surface of lower masking part
- 20: - Supply conduit
- 21: - Supply fitting
- 22a-d: - Overflow ports in sidewall
- 23: - Flow guide
- 24: - Rear exterior surface
- 25: - Parallel flow guide surface section
- 26: - Slanted flow guide surface section
- 27: - Finger-shaped surface sections
- 28a,b: - Winglets
- 29a,b: - Upright surface section
- 30: - Elongated overflow port
- 31: - Overflow conduit
- 32: - Overflow conduit fitting
- 33: - Return pipe
- 34: - Support structure
- 35a,b: - Arms
- 36a,b: - Claws
- 37: - First upper flow guidance part
- 38: - Second upper flow guidance part
- 39a,b: - Lower flow guidance parts
- 40a,b: - Pivot stubs
- 41a,b: - Upper biasing devices
- 42a,b: - Pivot stubs of lower flow guidance part
- 43a,b: - Lower biasing devices
- 44: - Inward-facing surface of first upper flow guidance part
- 45: - Strip of inward-facing surface of first upper flow guidance part
- 46: - Upper outward-facing surface section of first upper flow guidance part
- 47: - Lower outward-facing surface section of first upper flow guidance part
- 48: - Fold in outward-facing surface section of first upper flow guidance part
- 49: - Lower edge on first upper flow guidance part
- 50a,b: - Corners of lower outward-facing surface section of first upper flow guidance part
- 51a,b: - Lateral lower outward-facing surface sections of first upper flow guidance part
- 52a,b: - Facing surfaces of first upper flow guidance part
- 53: - Inward-facing surface of second upper flow guidance part
- 54: - Strip of inward-facing surface of second upper flow guidance part
- 55: - Upper outward-facing surface section of second upper flow guidance part
- 56: - Lower outward-facing surface section of second upper flow guidance part
- 57: - Fold in outward-facing surface of second upper flow guidance part
- 58: - Lower edge of second upper flow guidance part
- 59a,b: - Corners of lower outward-facing surface section of second upper flow guidance part
- 60a,b: - Lateral lower outward-facing surface sections of second upper flow guidance part
- 61a,b: - Facing surfaces of second upper flow guidance part
- 62: - Inward-facing surface of lower flow guidance part
- 63: - Strip of inward-facing surface of lower flow guidance part
- 64: - Slanting upper outward-facing surface section
- 65: - Upper edge of lower flow guidance part
- 66a,b: - First corners
- 67a,b: - Second corners
- 68: - Facing surface of lower flow guidance part
- 69a,b: - Plate-shaped segments of lower flow guidance part
- 70a,b: - Webs
- 71: - Lower outward-facing surface section of lower flow guidance part
- 72: - Fold in outward-facing surface section of lower flow guidance part

## Claims

1. Device for holding a planar substrate (1) in an apparatus for non-immersive wet-chemical treatment of the substrate (1), the device comprising:
a support structure (34),
wherein the support structure (34) comprises at least one part (36a,b) for engaging a support such as to suspend the support structure (34) in the apparatus;
at least one clamping device, supported by the support structure (34), for holding the substrate (1) in a plane; and
at least a first upper flow guidance part (37), arranged on one side of the plane and having an inward-facing surface (44) facing inwards and an outward-facing surface facing outwards with respect to the plane,
wherein the outward-facing surface comprises:
an upper outward-facing surface section (46) wettable by a stream of liquid directed onto the upper outward-facing surface section (46), and
a lower outward-facing surface section (47), extending from a transition between at least a central part of the upper outward-facing surface section (46) and the lower outward-facing surface section (47) to a lower edge (49), and
wherein a strip (45) of the inward-facing surface extends longitudinally along the lower edge (49) and transversely up to the lower edge (49), **characterised in that**
at least a central longitudinal section of the strip (45) is movable into engagement with a major surface of the substrate (1) over an entire length of that section.

2. Device according to claim 1,
wherein the at least one clamping devices comprise at least one upper clamping device, and
wherein an arm of the upper clamping device is arranged to engage a major surface of the substrate (1) at a level equal to or higher than the strip (45).

3. Device according to claim 2,
wherein the arm of the upper clamping device is arranged to engage the major surface between the plane and the strip (45).

4. Device according to claim 2 or 3,
wherein the first upper flow guidance part forms the arm of the upper clamping device.

5. Device according to any one of the preceding claims,
further comprising a second of the upper flow guidance parts (37,38), arranged on an opposite side of the plane to the first upper flow guidance part (37).

6. Device according to claim 5,
wherein the first and second upper flow guidance parts (37,38) are arranged to clamp the substrate (1) between them.

7. Device according to any one of the preceding claims,
wherein at least the first of the upper flow guidance parts (37,38) is pivotably attached to the support structure (34) with a pivot axis extending parallel to the plane.

8. Device according to any one of the preceding claims,
wherein at least the upper outward-facing surface section (46) is bounded laterally by surfaces (52a,b) facing towards each other and extending at an angle, e.g. transversely, to the plane.

9. Device according to any one of the preceding claims,
wherein the lower edge (49) extends between lateral edges of the lower outward-facing surface section (47), the lateral edges meeting the lower edge (49) at respective corners (50a,b) of the lower outward-facing surface section (47).

10. Device according to claim 9,
wherein the outward-facing surface further comprises lateral lower outward-facing surface sections (60a,b), separate from the lower outward-facing surface section (47) and adjoining the upper outward-facing surface section (46), and
wherein the lateral lower outward-facing surface sections (60a,b) and the upper outward-facing surface section (46) extend at an angle smaller than 180° between each other.

11. Device according to any one of the preceding claims,
wherein the at least one clamping devices comprise at least one lower clamping device,
arranged to engage the substrate (1) at a lower edge of the substrate (1).

12. Apparatus for non-immersive wet-chemical treatment of a planar substrate (1), comprising at least one device (2) according to any one of the preceding claims, at least one treatment station and at least one support to at least suspend the device in the treatment station,
wherein the treatment station includes a system for directing a respective stream of liquid onto the upper outward-facing surface section of a respective one of the at least one upper flow guidance parts (37,38).

13. Apparatus according to claim 12,
wherein the system for directing a respective stream of liquid onto the upper outward-facing surface section of a respective one of the at least one upper flow guidance parts (37,38) is configured to direct a downwardly-directed stream of liquid onto the upper outward-facing surface section.

14. Method of non-immersive wet-chemical treatment of a planar substrate (1), comprising:
mounting the substrate (1) to a device (2) according to any one of claims 1-11, and
directing a respective stream of liquid onto the upper outward-facing surface section (46,55) of a respective one of the at least one upper flow guidance parts (37,38).

15. Method according to claim 14,
wherein the stream of liquid is directed onto the upper outward-facing surface section (46,55) of the upper flow guidance part at a sufficient distance from the lower edge (49,58) to establish a laminar film flow at the lower edge (49,58).
